# EUROPEAN PATENT APPLICATION

(11) **EP 2 214 219 A2**
(43) Date of publication of application: **04.08.2010**
(21) Application number: 09012205.2
(22) Date of filing: 25.09.2009
(51) Int. Cl.: H01L 33/50, H01L 33/56

(54) **Light-emitting unit, method of manufacturing the same, and a light source device having the light-emitting unit**

(30) Priority: 29.01.2009 KR 20090006877
(71) Applicant: Samsung Electronics Co., Ltd., Suwon-si, Gyeonggi-do 442-742 (KR)
(72) Inventor: Shin, Jung-Han, Yongin-si Gyeonggi-do (KR); Park, Jae-Byung, Seongnam-si Gyeonggi-do (KR); Kang, Jong-Hyuk, Suwon-si Gyeonggi-do (KR); Kim, Gun-Woo, Yongin-si Gyeonggi-do (KR); Kim, Young-Hwan, Seongnam-si Gyeonggi-do (KR); Jang, Eun-Joo, Suwon-si Gyeonggi-do (KR); Kim, Hyoung-Joo, Uiwang-si Gyeonggi-do (KR); Jang, Hyo-Sook, Seongnam-si Gyeonggi-do (KR)
(74) Representative: Weitzel, Wolfgang

(57) **Abstract**

A light-emitting unit for emitting light includes a light-emitting element and a light-converting layer. The light-converting layer includes a nanoparticle and an additive having an oxidation speed faster than an oxidation speed of the nanoparticle. The light-converting layer is disposed on the light-emitting element to increase the durability of the light-emitting unit.

## Description

### BACKGROUND

### 1. Field of the Invention

Example embodiments of the present invention relate to a light-emitting unit, a method of manufacturing the light-emitting unit, and a light source device having the light-emitting unit. More particularly, embodiments of the present invention relate to a light-emitting unit that may be used in a liquid crystal display (LCD) apparatus, a method of manufacturing the light-emitting unit, and a light source device having the light-emitting unit.

### 2. Description of the Related Art

A light-emitting diode (LED) is a kind of a light-emitting element that uses a semiconductor including a compound emitting light having a specific wavelength in accordance with an energy band gap to emit light when a voltage is applied to a semiconductor. The LED has advantages in that power consumption is low and that luminous efficiency is excellent because the LED directly converts electrical energy to light, and thus the LED is widely and variably used in the industry.

An LED package including the LED is formed by mounting the LED on a substrate on which an electrical pattern is formed so that the LED connects to the electrical pattern. The LED mounted on the substrate may be capped by an epoxy resin, a silicone resin, etc. Recently, a light-converting layer having an inorganic fluorescent substance is included in the LED package so as to increase luminous efficiency and color reproduction, and thereby expand a range of the color reproduction. For example, when the LED emits ultraviolet (UV) light, the inorganic fluorescent substance is excited, the excited inorganic fluorescent substance emits visible light, and the visible light may be visible to a user. The color of the visible light may be varied in accordance with the inorganic fluorescent substance.

Technical development for increasing the durability of a light-emitting element has been conducted. For example, active research has been conducted to develop a light source having excellent luminous efficiency, a light-converting material capable of substituting for the inorganic fluorescent substance, and a structure of a light-emitting element. However, the development of the light source and the light-converting material needs time and high costs, and the development of the structure of the light-emitting element may not be sufficient for increasing the durability of the light-emitting element.

### SUMMARY

Example embodiments of the present invention provide a light-emitting unit capable of increasing the durability of the light-emitting unit.

Example embodiments of the present invention also provide a method of manufacturing the light-emitting unit.

Example embodiments of the present invention also provide a light source device having the light-emitting unit.

According to one aspect of the present invention, a light-emitting unit includes a light-emitting element and a light-converting layer. The light-emitting unit emits light. The light-converting layer includes a nanoparticle and an additive having an oxidation speed faster than an oxidation speed of the nanoparticle. The light-converting layer is disposed on the light-emitting element.

In one embodiment, the additive may include at least one selected from a group formed with a phenolic compound, a phosphite compound, a quinoline compound and a piperidine compound.

In one embodiment, the light-converting layer may further include an encapsulant resin fixing the nanoparticle and the additive to a base substrate, on which the light-emitting element is mounted.

In another aspect of the present invention, there is provided a method of manufacturing a light-emitting unit. In the method, a light-converting layer is formed by coating a nanoparticle and an additive having an oxidation speed faster than an oxidation speed of the nanoparticle on the base substrate on which a light-emitting element emitting light is mounted.

In one embodiment, the light-converting layer is formed by coating a mixture including the nanoparticle, the additive and an encapsulant resin.

According to still another aspect of the present invention, a light source device includes a printed circuit board (PCB) and a light-emitting unit. The light-emitting unit includes a light-emitting element and a light-converting layer comprising a nanoparticle and an additive having an oxidation speed faster than an oxidation speed of the nanoparticle to convert first light emitted from the light-emitting unit to second light. The light-emitting unit is disposed on the PCB.

In one embodiment, a plurality of light-emitting units are divided into a plurality of driving blocks to be driven in correspondence with the respective driving blocks.

According to the present invention, oxidation of a nanoparticle in a light-converting layer may be prevented using an additive, and thus the durability of a light-emitting unit having the nanoparticle may be increased. Therefore, the present invention may increase color reproduction using a nanoparticle and increase the durability of a light-emitting unit, and thus may decrease costs for replacing the light-emitting unit.

### BRIEF DESCRIPTION OF THE DRAWINGS

The above and other features and advantages of the present invention will become more apparent by describing in detailed example embodiments thereof with reference to the accompanying drawings, in which:

FIG 1 is a cross-sectional view illustrating a light-emitting unit according to an example embodiment of the present invention;

FIG. 2A is an enlarged view illustrating a surface of the nanoparticle before the nanoparticle receives external influence;

FIG. 2B is an enlarged view illustrating the surface of the nanoparticle, of which an arrangement of an outer portion is changed by oxygen, light energy or heat energy;

FIG. 3A is an analysis spectrum corresponding to a combining energy range of about 1,015 eV through about 1,030 eV of a first sample baked at about 150°C;

FIG. 3B is an analysis spectrum corresponding to a combining energy range of about 1,015 eV through about 1,030 eV of a second sample baked at about 200°C;

FIG. 3C is an analysis spectrum corresponding to a combining energy range of about 1,015 eV through about 1,030 eV of a third sample baked at about 250°C;

FIG. 3D is an analysis spectrum corresponding to a combining energy range of about 1,015 eV through about 1,030 eV of a fourth sample baked at about 250°C and ultraviolet (UV) light is irradiated on the fourth sample;

FIG. 4A is an analysis spectrum corresponding to a combining energy range of about 400 eV through about 409 eV of the first sample baked at about 150°C;

FIG. 4B is an analysis spectrum corresponding to a combining energy range of about 400 eV through about 409 eV of the second sample baked at about 200°C;

FIG. 4C is an analysis spectrum corresponding to a combining energy range of about 400 eV through about 409 eV of the third sample baked at about 250°C;

FIG. 4D is an analysis spectrum corresponding to a combining energy range of about 400 eV through about 409 eV of the fourth sample baked at about 250°C and the UV light is irradiated on the fourth sample;

FIG. 5 is a concept diagram illustrating a reaction of the additive and oxygen;

FIG. 6 is a graph illustrating the luminous efficiency of the light-emitting units manufactured according to Example Embodiment 1, Example Embodiment 2 and Comparative Example Embodiment in accordance with time;

FIG. 7 is a cross-sectional view illustrating a method of manufacturing the light-emitting unit of FIG. 1;

FIG. 8 is a cross-sectional view illustrating a display apparatus including the light-emitting unit of FIG. 1;

FIG. 9 is a cross-sectional view illustrating a light-emitting unit including a buffer layer;

FIG. 10 is a cross-sectional view illustrating a method of manufacturing the light-emitting unit of FIG. 9;

FIG 11 is a cross-sectional view illustrating a light-emitting unit including a middle layer and a protective layer;

FIG. 12 is a cross-sectional view illustrating a light-emitting unit including a spacer; and

FIG. 13 is a cross-sectional view illustrating a method of manufacturing the light-emitting unit of FIG. 12.

### DETAILED DESCRIPTION

The present invention is described more fully hereinafter with reference to the accompanying drawings, in which example embodiments of the present invention are shown. The present invention may, however, be embodied in many different forms and should not be construed as limited to the example embodiments set forth herein. Rather, these example embodiments are provided so that this disclosure will be thorough and complete, and will fully convey the scope of the present invention to those skilled in the art. In the drawings, the sizes and relative sizes of layers and regions may be exaggerated for clarity.

It will be understood that when an element or layer is referred to as being "on," "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

It will be understood that, although the terms first, second, third, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular example embodiments only and is not intended to be limiting of the present invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Example embodiments of the invention are described herein with reference to cross-sectional illustrations that are schematic illustrations of idealized example embodiments (and intermediate structures) of the present invention. As such, variations from the shapes of the illustrations as a result, for example, of manufacturing techniques and/or tolerances, are to be expected. Thus, example embodiments of the present invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the present invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, the present invention will be explained in detail with reference to the accompanying drawings.

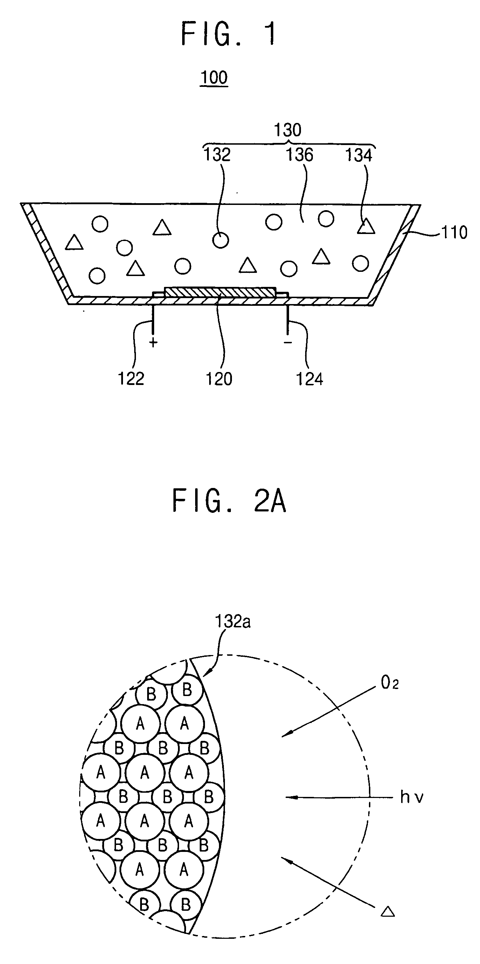

FIG. 1 is a cross-sectional view illustrating a light-emitting unit according to an example embodiment of the present invention.

Referring to FIG. 1, a light-emitting unit 100 according to the present example embodiment includes a reflector mold 110, a light-emitting element 120 and a light-converting layer 130.

The reflector mold 110 is a frame forming the light-emitting unit 100 to have a single structure, and the reflector mold 110 includes a bottom surface and side walls connected to the bottom surface. An internal space of the reflector mold 110 may be defined by the bottom surface and the side walls. The light-emitting element 120 and the light-converting layer 130 may be formed in the internal space. The reflector mold 110 may guide first light emitted from the light-emitting element 120 to reflect and/or diffuse the first light into the light-converting layer 130 without loss of the first light.

The light-emitting element 120 may be mounted on a bottom surface of the reflector mold 110. The light-emitting element 120 may be a light-emitting diode (LED). The light-emitting element 120 may receive power from the exterior (not shown) through a first wire 122 and a second wire 124. The light-emitting element 120 may emit the first light by receiving the power. For example, the first light may be ultraviolet (UV) light. The light-emitting element 120 may include a p-electrode and an n-electrode. The p-electrode of the light-emitting element 120 may be electrically connected to the first wire 122 and the n-electrode of the light-emitting element 120 may be electrically connected to the second wire 124.

The light-converting layer 130 is formed on the light-emitting element 120. The light-converting layer 130 may convert the first light into second light having a wavelength different from a wavelength of the first light. The light-converting layer 130 may be formed in the reflector mold 110 to cover the light-emitting element 120. The light-converting layer 130 may contact with the light-emitting element 120. The light-converting layer 130 includes a nanoparticle 132, an additive 134 and an encapsulant resin 136.

The first light is absorbed to the nanoparticle 132, and the nanoparticle 132 emits the second light. For example, the second light may be visible light displaying a white color, a blue color, a green color, a red color, etc. A plurality of nanoparticles 132 may be uniformly distributed in the light-converting layer 130.

The nanoparticle may include a transition element. For example, the transition element that may be used for the nanoparticle 132 may include zinc (Zn), cadmium (Cd), mercury (Hg), aluminum (Al), gallium (Ga), indium (In), silicon (Si), germanium (Ge), tin (Sn), lead (Pb), etc. These may be used alone or in combination. The nanoparticle 132 may include a nitride of a simple transition metal, a phosphide of the simple transition element, an arsenide of the simple transition element, an antimonide of the simple transition element, an oxide of the simple transition element, a sulfide of the simple transition element, a selenide of the simple transition element and a telluride of the simple transition element. Each of the nitride of the simple transition metal, the phosphide of the simple transition element, the arsenide of the simple transition element, the antimonide of the simple transition element, the oxide of the simple transition element, the sulfide of the simple transition element, the selenide of the simple transition element and the telluride of the simple transition element may independently form the nanoparticle 132. Alternatively, the nitride of the simple transition metal, the phosphide of the simple transition element, the arsenide of the simple transition element, the antimonide of the simple transition element, the oxide of the simple transition element, the sulfide of the simple transition element, the selenide of the simple transition element and the telluride of the simple transition element may be arranged in a core-shell structure to form the nanoparticle 132. For example, the nanoparticle 132 may include cadmium sulfide (CdS), cadmium selenide (CdSe), cadmium telluride (CdTe), zinc sulfide (ZnS), zinc selenide (ZnSe), zinc telluride (ZnTe), zinc oxide (ZnO), mercury sulfide (HgS), mercury selenide (HgSe), mercury telluride (HgTe), gallium nitride (GaN), gallium phosphide (GaP), gallium arsenide (GaAs), gallium antimonide (GaSb), aluminum nitride (AlN), aluminum phosphide (AlP), aluminum arsenide (AlAs), aluminum antimonide (AlSb), indium nitride (InN), indium phosphide (InP), indium arsenide (InAs), indium antimonide (InSb), tin sulfide (SnS), tin selenide (SnSe), tin telluride (SnTe), lead sulfide (PbS), lead selenide (PbSe), lead telluride (PbTe), etc. For example, the nanoparticle 132 having the core-shell structure may include cadmium selenium/zinc sulfide (CdSe/ZnS), cadmium selenium//zinc sulfide/cadmium sulfide zinc sulfide (CdSe//ZnS/CdSZnS), etc.

The additive 134 is a compound preventing oxidation of the nanoparticle 132. A reactivity of the additive 134 to oxygen is higher than the reactivity of the nanoparticle 132 to oxygen, thus the additive 134 reacts with the oxygen faster than the nanoparticle 132 does so that oxidation of the nanoparticle 132 may be prevented. That is, an oxidation speed of the additive 134 is faster than an oxidation speed of the nanoparticle 132. The additive 134 may be uniformly distributed in the light-converting layer 130.

For example, the additive 134 may include a phenolic compound, a phosphite compound, a quinoline compound, a piperidine compound, etc. For example, the phenolic compound may include 2,6-di-t-butyl-4-methylphenol, tetrakismethylene(3,5-di-t-butyl-4-hydroxyhydrocinnamate)methane, octadecyl 3-(3',5'-di-t-butyl-4'-hydroxyphenyl)propionate, octadecyl 3,5-di-t-butyl-4-hydroxyhydrocinnamate, 3,5-bis(1,1-dimethylethyl)4-hydroxybenzenepropanoic acid, 2,2'-thiodiethylene bis[(3,5-di-t-butyl-4-hydroxyphenyl)propionate], 2,2'-methylidene bis[4,6-di-t-butylphenol], 1,3,5-tri(3,5-di-t-butyl-4-hydroxybenzyl)isocyanurate, 2,2'-methylene bis[(6-t-butyl-4-hydroxy-5-methylphenyl)propionate], N,N'-hexamethylene bis[3-(3,5-di-t-butyl-4-hydroxyphenyl)propionamide], 4,4'-thiobis(2-t-butyl-5-methylphenol), 2,2'-thiobis(6-t-butyl-4-methylphenol), 2,2'-methylene bis[4-methyl-6-(1-methylcyclohexyl)phenol], 1,2-bis(3,5-di-t-butyl-4-hydroxyhydrocinnamyl)hydrazine, etc. For example, the phosphite compound may include tris(2,4-di-t-butylphenyl)phosphite, bis(2,4-di-t-butylphenyl)pentaerythritol diphosphite, bis(2,4-dicumylphenyl) pentaerythritol diphosphite, tri-(4-n-nonylphenyl)phosphite, tetrakis(2,4-di-t-butyl-phenyl)4,4'-biphenylene-diphosphite, etc. For example, the quinoline compound may include trimethyl quinoline. For example, the piperidine compound may include bis(2,2,6,6-tetramethyl-4-piperidinyl)sebacate.

The encapsulant resin 136 may be interposed between the nanoparticle 132 and the additive 134 to form the light-converting layer 130. The encapsulant resin 136 may be interposed between the nanoparticle 132 and the additive 134 to prevent the nanoparticle 132 and the additive 134 from flowing and moving. The nanoparticle 132 and the additive 134 may be fixed in the reflector mold 110 by the encapsulant resin 136.

For example, the encapsulant resin 136 may include a styrene polymer, an acrylate polymer, a carbonate polymer, an ethylene polymer, a siloxane polymer, an epoxy polymer, etc.

The light-converting layer 130 may further include a fluorescent compound that has been conventionally used. The fluorescent compound may include an organic fluorescent substance, an inorganic fluorescent substance, etc. The fluorescent compound may be fixed in the reflector mold 110 by the encapsulant resin 136.

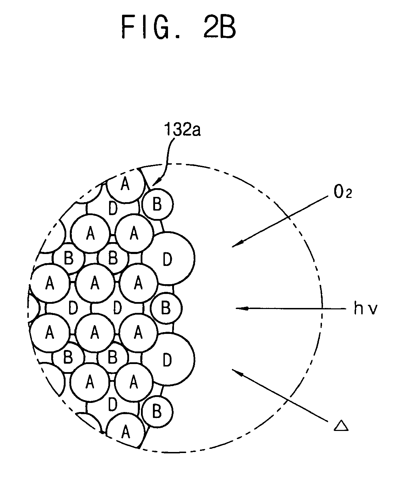

FIGS. 2A and 2B are enlarged-views illustrating a surface of the nanoparticle illustrating an oxidation reaction of the nanoparticle of FIG. 1.

Particularly, FIG. 2A is an enlarged view illustrating a surface of the nanoparticle before the nanoparticle receives external influence and FIG. 2B is an enlarged view illustrating the surface of the nanoparticle, of which an arrangement of an outer portion is changed by oxygen, light energy, or heat energy.

Referring to FIG. 2A, the nanoparticle 132 may include a first atom A and a second atom B. The first atom A and the second atom B may be regularly arranged to form the nanoparticle 132.

For example, the first atom A and the second atom B may be regularly arranged from a core to an outer portion 132a to form the nanoparticle 132. Alternatively, atoms different from the first atom A and the second atom B may be regularly arranged in the core, and the first atom A and the second atom B may be regularly arranged in the outer portion 132a. The first atom A may include a metal. The first atom A may include zinc, cadmium, mercury, aluminum, gallium, indium, etc. The second atom B may include sulfur, oxygen, nitrogen, phosphorus, arsenic, selenium, tellurium, antimony, etc.

The nanoparticle 132 is disposed in the light-converting layer 130, and the nanoparticle 132 may be exposed to light energy hv or heat energy Δ. Additionally, the nanoparticle 132 may be exposed to oxygen (O₂) trapped in the light-converting layer 130 in a process forming the light-converting layer 130.

Referring to FIG. 2B, the nanoparticle exposed to the light energy hv, the heat energy Δ, or the oxygen includes the first atom A, the second atom, and a side reaction product D.

The nanoparticle 132 is supposed to include the first and the second atoms A and B, however the side reaction product D may be generated by oxygen (O₂) in the nanoparticle 132. When the side reaction product D is formed in the outer portion 132a, an arrangement structure of the nanoparticle 132 is changed. The side reaction product D is generated by a reaction of the second atom B and oxygen. For example, when the second atom B is sulfur, the side reaction product D may be a sulfuric acid ion. The side reaction product D may combine with the first atom A to generate a metal sulfate. For example, the metal sulfate may be zinc sulfate.

When the arrangement structure of the nanoparticle 132 is changed, the luminous efficiency of the nanoparticle 132 is degraded by defects due to a variation of an arrangement regularity of the nanoparticle 132. A generation of the side reaction product D may be accelerated by the light energy hv or the heat energy Δ.

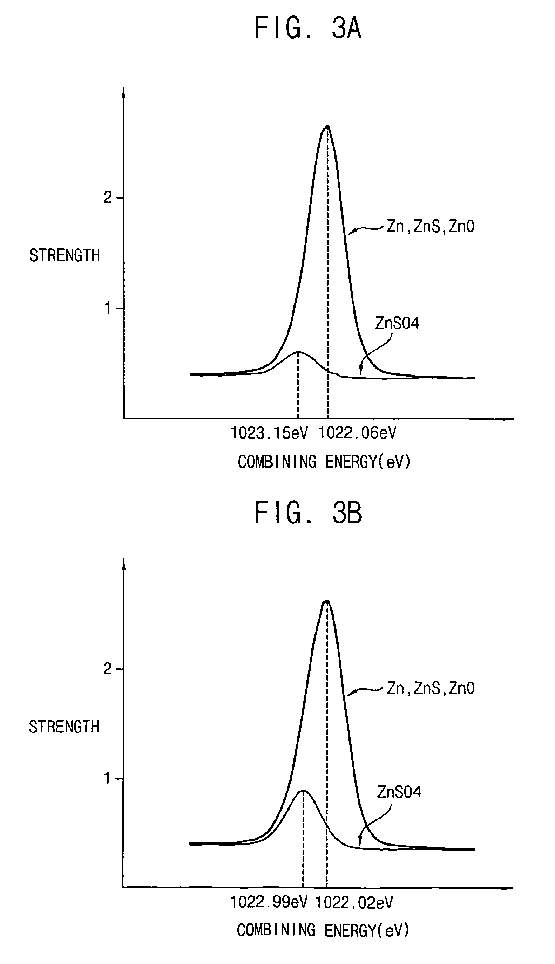

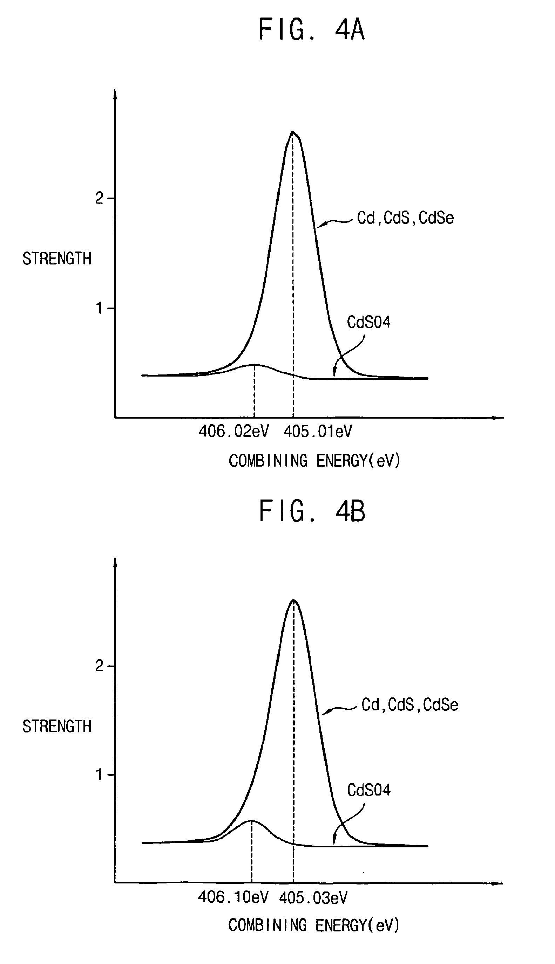

Hereinafter, a result of an experiment with respect to a generation of the side reaction product D in the nanoparticle will be described with reference to FIGS. 3A to 3D and FIGS. 4A to 4D.

A nanoparticle solution was prepared by dissolving cadmium selenium/zinc sulfide/cadmium sulfide zinc sulfide (CdSe/ZnS/CdSZnS) including cadmium selenium (CdSe) arranged in a core and zinc sulfide (ZnS) and cadmium sulfide zinc sulfide (CdSZnS) arranged in an outer portion and displaying a green color into a toluene, and the nanoparticle solution was spin-coated on three glass substrates to prepare samples. The glass substrates, on which the samples were formed, were baked at about 150°C, about 200°C and about 250°C for an hour, respectively. The baked samples were analyzed using a Quantera (product name, ULVAC-PHI, Inc., Japan) device, which is an x-ray photoelectron spectroscopy (XPS) device, having about 100 µm of a beam size and about 69 eV of energy, and thus obtained spectrums are illustrated in FIGS. 3A to 3C.

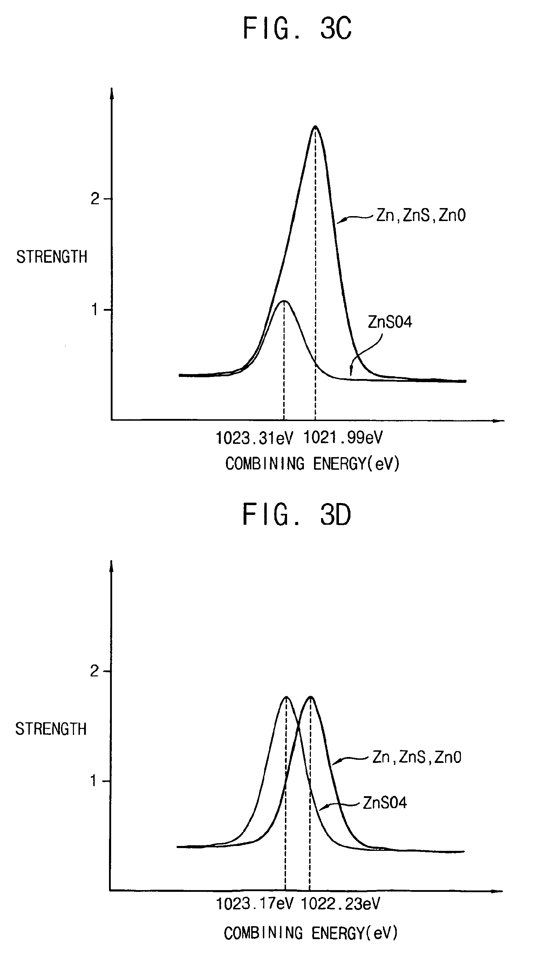

An UV light having a wavelength of about 444 nm and an intensity of about 350 mA was irradiated to the sample baked at about 250°C. The sample, to which the UV light was irradiated, was analyzed using the Quantera, and thus a spectrum illustrated in FIG 3D was obtained.

FIGS. 3A to 3D and FIGS. 4A to 4D are XPS spectrums of a nanoparticle including cadmium selenium//zinc sulfide/cadmium sulfide zinc sulfide (CdSe//ZnS/CdSZnS) in accordance with a temperature.

In FIGS. 3A to 3D and FIGS. 4A to 4D, an x-axis represents a combining energy between atoms and an y-axis represents a strength of a signal of an electron emitted from the sample after the sample absorbs x-ray and amplified by an electronic amplifier. When the strength of the y-axis is high, that means that the sample includes a relatively large amount of a combining structure corresponding to a combining energy of the strength.

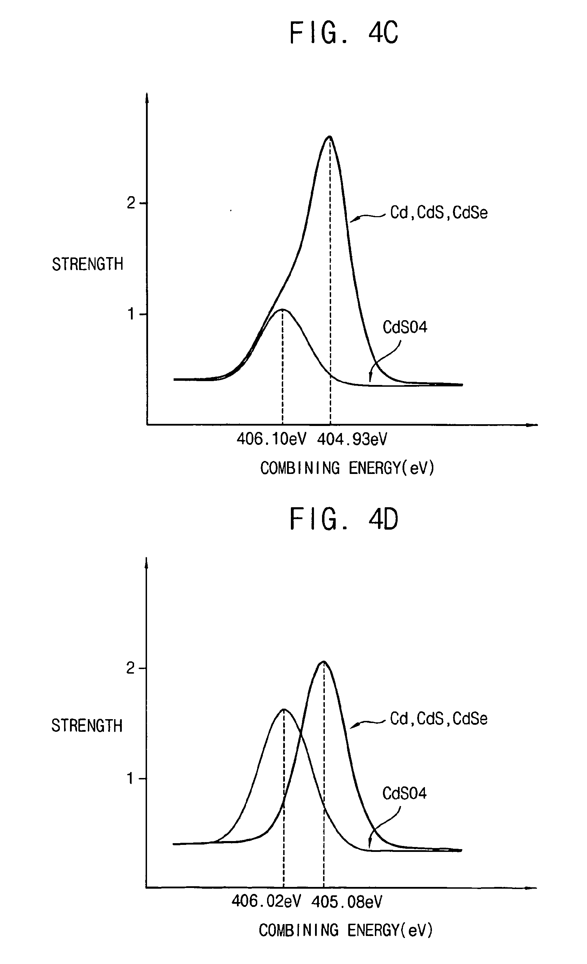

FIG. 3A illustrates an analysis spectrum corresponding to a combining energy range of about 1,015 eV through about 1,030 eV of a first sample baked at about 150°C, FIG. 4A illustrates an analysis spectrum corresponding to a combining energy range of about 400 eV through about 409 eV of the first sample baked at about 150°C. FIG. 3B illustrates an analysis spectrum corresponding to a combining energy range of about 1,015 eV through about 1,030 eV of a second sample baked at about 200°C, FIG. 4B illustrates an analysis spectrum corresponding to a combining energy range of about 400 eV through about 409 eV of the second sample baked at about 200°C. FIG. 3C illustrates an analysis spectrum corresponding to a combining energy range of about 1,015 eV through about 1,030 eV of a third sample baked at about 250°C, FIG. 4C illustrates an analysis spectrum corresponding to a combining energy range of about 400 eV through about 409 eV of the third sample baked at about 250°C. FIG. 3D illustrates an analysis spectrum corresponding to a combining energy range of about 1,015 eV through about 1,030 eV of a fourth sample baked at about 250°C and exposed to UV light after baked, FIG. 4D illustrates an analysis spectrum corresponding to a combining energy range of about 400 eV through about 409 eV of the fourth sample baked at about 250°C and exposed to UV light after baked.

Referring to FIG. 3A, when the first sample was analyzed by the XPS device, a first spectrum having a first peak at about 1,022.06 eV and a second spectrum having a second peak at about 1,023.15 eV and weaker than the first spectrum were obtained.

When a sum of a first area of the first spectrum having the first peak and a second area of the second spectrum having the second peak is defined as about 100, the first area is about 91.06 and the second area is about 8.94. The first peak denotes that the first sample includes zinc (Zn), zinc sulfide (ZnS), zinc oxidation (ZnO) having a combining energy of about 1,022.06 eV. The second peak denotes that the first sample includes zinc sulfate (ZnSO₄) having a combining energy of about 1,023.15 eV. Thus, it can be noted that a portion of the first sample formed zinc sulfate (ZnSO₄) by reacting with oxygen at about 150°C.

Referring to FIG. 3B, when the second sample was analyzed by the XPS device, in the combining energy range of about 1,015 eV through about 1,030 eV, a first spectrum having a first peak at about 1,022.02 eV and a second spectrum having a second peak at about 1,022.99 eV and weaker than the first spectrum are obtained.

When a sum of a first area of the first spectrum having the first peak and a second area of the second spectrum having the second peak is defined as about 100, the first area is about 80.08 and the second area is about 19.92. The first peak denotes that the second sample includes zinc (Zn), zinc sulfide (ZnS), zinc oxidation (ZnO) having a combining energy of about 1,022.02 eV. The second peak denotes that the second sample includes zinc sulfate (ZnSO₄) having a combining energy of about 1,022.99 eV. Thus, it can be noted that a portion of the second sample not including zinc sulfate (ZnSO₄) forms zinc sulfate (ZnSO₄) by reacting with oxygen at about 200°C.

The second area of the second sample is larger than the second area of the first sample. Thus, it can be noted that quantity of zinc sulfate (ZnSO₄) contained in the second sample baked at about 200°C is greater than quantity of zinc sulfate (ZnSO₄) contained in the first sample baked at about 150°C.

Referring to FIG. 3C, when the third sample was analyzed by the XPS device, in the combining energy range of about 1,015 eV through about 1,030 eV, a first spectrum having a first peak at about 1,021.99 eV and a second spectrum having a second peak at about 1,023.31 eV and weaker than the first spectrum were obtained.

When a sum of a first area of the first spectrum having the first peak and a second area of the second spectrum having the second peak is defined as about 100, the first area is about 75.30 and the second area is about 24.70. The first peak denotes that the third sample includes zinc (Zn), zinc sulfide (ZnS), zinc oxidation (ZnO) having a combining energy of about 1,021.99 eV. The second peak denotes that the third sample includes zinc sulfate (ZnSO₄) having a combining energy of about 1,023.31 eV. Thus, it can be noted that a portion of the third sample formed zinc sulfate (ZnSO₄) by reacting with oxygen at about 250°C.

The second area of the third sample is larger than the second area of the first and second samples. That is, quantity of zinc sulfate (ZnSO₄) contained in the third sample baked at about 250°C is greater than quantity of zinc sulfate (ZnSO₄) contained in the first sample baked at about 150°C and the second sample baked at about 200°C.

Thus, it can be noted that the nanoparticle including cadmium selenium//zinc sulfide/cadmium sulfide zinc sulfide (CdSe//ZnS/CdSZnS) forms zinc sulfate (ZnSO₄) by oxidizing sulfur disposed in an outer portion of the nanoparticle, when a temperature is increased.

Referring to FIG. 3D, when the fourth sample was analyzed by the XPS device, in the combining energy range of about 1,015 eV through about 1,030 eV, a first spectrum having a first peak at about 1,022.23 eV and a second spectrum having a second peak at about 1,023.17 eV and weaker than the first spectrum were obtained.

When a sum of a first area of the first spectrum having the first peak and a second area of the second spectrum having the second peak is defined as about 100, the first area is about 50.36 and the second area is about 49.64. The first peak denotes that the fourth sample includes zinc (Zn), zinc sulfide (ZnS), zinc oxidation (ZnO) having a combining energy of about 1,022.23 eV. The second peak denotes that the fourth sample includes zinc sulfate (ZnSO₄) having a combining energy of about 1,023.17 eV. Thus, it can be noted that about a half of the fourth sample having not included zinc sulfate (ZnSO₄) formed zinc sulfate (ZnSO₄) by reacting with oxygen at about 250°C.

The second area of the fourth sample is larger than the second area of the third sample. Thus, it can be noted that an oxidation reaction of the nanoparticle in a case in which the nanoparticle is exposed to the light energy is stronger than in a case in which the nanoparticle is not exposed to the light energy.

Referring to FIG. 4A, when the first sample was analyzed, in the combining energy range of about 400 eV through about 409 eV, a third spectrum having a third peak at about 405.01 eV and a fourth spectrum having a fourth peak at about 406.02 eV and weaker than the third spectrum were obtained.

When a sum of a third area of the third spectrum having the third peak and a fourth area of the fourth spectrum having the fourth peak is defined as about 100, the third area is about 95.60 and the fourth area is about 4.40. The third peak denotes that the first sample includes cadmium (Cd), cadmium sulfide (CdS), cadmium selenium (CdSe) having a combining energy of about 405.01 eV. The fourth peak denotes that the first sample includes cadmium sulfate (CdSO₄) having a combining energy of about 406.02 eV. Thus, it can be noted that a portion of the first sample formed cadmium sulfate (CdSO₄) by reacting with oxygen at about 150°C.

Referring to FIG. 4B, when the second sample was analyzed, in the combining energy range of about 400 eV through about 409 eV, a third spectrum having a third peak at about 405.03 eV and a fourth spectrum having a fourth peak at about 406.10 eV and weaker than the third spectrum were obtained.

When a sum of a third area of the third spectrum having the third peak and a fourth area of the fourth spectrum having the fourth peak is defined as about 100, the third area is about 93.48 and the fourth area is about 6.52. The third peak denotes that the second sample includes cadmium (Cd), cadmium sulfide (CdS), cadmium selenium (CdSe) having a combining energy of about 405.03 eV. The fourth peak denotes that the second sample includes cadmium sulfate (CdSO₄) having a combining energy of about 406.10 eV. Thus, it can be noted that a portion of the second sample formed cadmium sulfate (CdSO₄) by reacting with oxygen at about 200°C.

Referring to FIG. 4C, when the third sample was analyzed, in the combining energy range of about 400 eV through about 409 eV, a third spectrum having a third peak at about 404.93 eV and a fourth spectrum having a fourth peak at about 406.10 eV and weaker than the third spectrum were obtained.

When a sum of a third area of the third spectrum having the third peak and a fourth area of the fourth spectrum having the fourth peak is defined as about 100, the third area is about 75.40 and the fourth area is about 24.60. The third peak denotes that the third sample includes cadmium (Cd), cadmium sulfide (CdS), cadmium selenium (CdSe) having a combining energy of about 404.93 eV. The fourth peak denotes that the third sample includes cadmium sulfate (CdSO₄) having a combining energy of about 406.10 eV. Thus, it can be noted that a portion of the third sample formed cadmium sulfate (CdSO₄) by reacting with oxygen at about 250°C.

Referring to FIG. 4D when the fourth sample was analyzed, in the combining energy range of about 400 eV through about 409 eV, a third spectrum having a third peak at about 405.08 eV and a fourth spectrum having a fourth peak at about 406.02 eV and weaker than the third spectrum were obtained.

When a sum of a third area of the third spectrum having the third peak and a fourth area of the fourth spectrum having the fourth peak is defined as about 100, the third area is about 56.98 and the fourth area is about 43.02. The third peak denotes that the third sample includes cadmium (Cd), cadmium sulfide (CdS), cadmium selenium (CdSe) having a combining energy of about 405.08 eV. The fourth peak denotes that the third sample includes cadmium sulfate (CdSO₄) having a combining energy of about 406.02 eV. Thus, it can be noted that about a half of the fourth sample having not included cadmium sulfate (CdSO₄) formed cadmium sulfate (CdSO₄) by reacting with oxygen at about 250°C.

The second area of the fourth sample is larger than the second area of the third sample. Thus, it can be noted that an oxidation reaction of the nanoparticle in a case in which the nanoparticle is exposed to the light energy is stronger than in a case in which the nanoparticle is not exposed to the light energy.

According to the above-mentioned description with reference to FIGS. 2A to 2B, FIGS. 3A to 3D and FIGS. 4A to 4D, it can be noted that an outer portion of the nanoparticle reacts with oxygen, and that the oxidation reaction is stronger when the temperature is increased. Additionally, it can be noted that the oxidation reaction is much stronger when light energy, for example UV light, is applied to the nanoparticle.

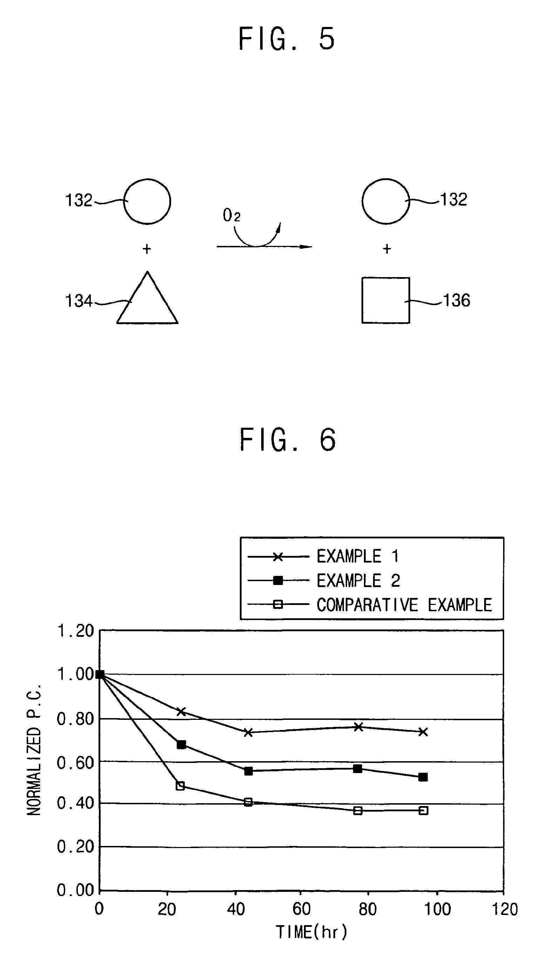

According to the present invention, the additive reacts with oxygen faster than the nanoparticle does, and thus oxidation of the nanoparticle may be prevented. Therefore, a generation of the side reaction product D that is a result of the oxidation reaction of the nanoparticle may be prevented. Hereinafter, an oxidation prevention mechanism of the nanoparticle is described with reference to FIG. 5.

FIG 5 is a concept diagram illustrating a reaction of the additive and oxygen.

Referring to FIG. 5, when oxygen (O₂) is applied to the nanoparticle 132 mixed with the additive 134, oxygen may be combined with the additive 134 because the reactivity of the nanoparticle 132 to the oxygen is less than the reactivity of the additive 134 to the oxygen. That is, an oxidation speed of the additive 134 is faster than an oxidation speed of the nanoparticle 132. Therefore, the nanoparticle 132 may not be damaged due to oxygen, and the additive 134 combines with oxygen to form a final product 136.

The additive 134 combines with oxygen, and thus an oxidation reaction of the nanoparticle 132 may be prevented. Even if the oxidation reaction of the nanoparticle 132 starts, the additive 134 may be combined with a radical and/or an ion that is generated in the oxidation reaction of the nanoparticle 132. Therefore, the additive 134 may lower a speed of the oxidation reaction of the nanoparticle 132 that may be accelerated by the radical and/or the ion.

For example, when the additive 134 includes a piperidine compound, a nitrogen atom of the additive 134 reacts with oxygen, the additive 134 reacted with oxygen combines with an instable radical that is generated in the oxidation reaction of the nanoparticle 132, and thus the additive 134 may stabilize the radical. Thus, another oxidation reaction that may be caused by the radical may be prevented. Therefore, the speed of the oxidation reaction of the nanoparticle 132 may be reduced.

Hereinafter, a method of manufacturing a nanoparticle including cadmium selenium//zinc sulfide/cadmium sulfide zinc sulfide (CdSe//ZnS/CdSZnS) and an effect of an additive will be described with reference to Example 1, Example 2 and Comparative Example 1.

### Manufacturing of nanoparticle

About 60 mL of trioctylamine (TOA), about 0.4 g of octadecyl phosphonic acid and about 0.29 mmol of cadmium oxide were put into a 100 mL three-necked flask having a flux condenser to prepare a reaction mixture, and a reaction temperature was controlled to be about 320°C with the reaction mixture being stirred in the flask. Selenium (Se) powder was mixed with trioctylphosphine (TOP) to prepare a selenium-TOP (Se-TOP) complex solution, of which a selenium density was about 2M (mole density). About 6 mL of the Se-TOP complex solution having the selenium density of about 2M (mole density) was mixed with the mixture quickly, and a reaction was maintained for about two minutes. After the end of the reaction, the temperature of the reaction mixture was dropped to a normal temperature (about 25°C), and ethanol was added to perform a centrifugal separation. Upper liquid was removed from the mixture and the remaining precipitation was dispersed in toluene. The diffused precipitation was combined with cadmium selenide (CdSe) liquid absorbing light at about 465 nm.

About 20 mL of trioctylamine (TOA), about 0.2 g of oleic acid, and about 0.2 mmol of zinc acetate were put into a 100 mL three-necked flask having a flux condenser to prepare a reaction mixture, and a reaction temperature was controlled to be about 300°C with the reaction mixture being stirred in the flask. The cadmium selenide (CdSe) liquid was mixed with the reaction mixture, sulfide-TOP complex liquid is mixed with the mixture slowly, and the reaction was maintained for about one hour to form zinc sulfide (ZnS) on a surface of the cadmium selenide (CdSe). The cadmium selenide (CdSe) and the zinc sulfide (ZnS) are diffused to form cadmium selenium//zinc sulfide (CdSe//ZnS) compound nanoparticle. After the end of the reaction, the temperature of the reaction mixture was dropped to a normal temperature (about 25°C), and ethanol was added to perform a centrifugal separation. Upper liquid was removed from the mixture and the remaining precipitation was dispersed in toluene. The diffused precipitation was combined with cadmium selenium//zinc sulfide (CdSe//ZnS) liquid absorbing light at about 450 nm.

About 20 mL of trioctylamine (TOA), about 0.2 g of oleic acid, about 0.05 mmol of cadmium acetate hydrate, and about 0.2 mmol of zinc acetate were put into a 100 mL three-necked flask having a flux condenser to prepare a reaction mixture, and a reaction temperature was controlled to be about 300°C with the reaction mixture being stirred in the flask. The cadmium selenium//zinc sulfide (CdSe//ZnS) liquid was mixed with the reaction mixture, sulfide-TOP complex liquid is mixed with the mixture slowly, and the reaction was maintained for about one hour to form cadmium sulfide zinc sulfide (CdSZnS) on a surface of the cadmium selenium//zinc sulfide (CdSe//ZnS). The cadmium selenium/zinc sulfide (CdSe/ZnS) and the cadmium sulfide zinc sulfide (CdSZnS) are diffused to form cadmium selenium//zinc sulfide/cadmium sulfide zinc sulfide (CdSe//ZnS/CdSZnS) compound nanoparticle. After the end of the reaction, the temperature of the reaction mixture was dropped to a normal temperature (about 25°C), and ethanol was added to perform a centrifugal separation. Upper liquid was removed from the mixture and the remaining precipitation was dispersed in toluene. The diffused precipitation was combined with cadmium selenium//zinc sulfide/cadmium sulfide zinc sulfide (CdSe//ZnS/CdSZnS) liquid emitting light at about 530 nm. A quantum efficiency of cadmium selenium//zinc sulfide/cadmium sulfide zinc sulfide (CdSe//ZnS/CdSZnS) is about 97%.

### Example 1 - manufacturing a light-emitting unit

About 1 mL of OE6630 (product name, Dow Coming Corp., U.S.A.) was added to about 1 mL (about 0.01 of light density) of cadmium selenium//zinc sulfide/cadmium sulfide zinc sulfide (CdSe//ZnS/CdSZnS) solution and about 0.01 g of 2,6-di-t-butyl-4-methylphenol to uniformly mix with each other. Thereafter, toluene was removed from the mixture by maintaining the mixture in a vacuum state for about an hour to prepare a nanoparticle-resin complex solution. The nanoparticle-resin complex solution was uniformly coated in the reflector mold, on which a light-emitting element emitting blue light of about 444 nm was mounted, formed from silver (Ag). The nanoparticle-resin complex solution was baked at about 150°C for about two hours to manufacture a light-emitting unit.

### Example 2 - manufacturing a light-emitting unit

A light-emitting unit was manufactured using substantially the same method as Example 1 except for using about 0.01 g of tris(2,4-di-t-butylphenyl)phosphite) instead of 2,6-di-t-butyl-4-methylphenol.

### Comparative Example 1 - manufacturing a light-emitting unit

About 1 mL of OE6630 (product name, Dow Coming Corp., U.S.A.) was added to about 1 mL (about 0.01 of light density) of cadmium selenium//zinc sulfide/cadmium sulfide zinc sulfide (CdSe//ZnS/CdSZnS) solution to uniformly mix with each other. Thereafter, toluene was removed from the mixture by maintaining the compound in a vacuum state for about an hour to prepare a nanoparticle-resin complex solution. The nanoparticle-resin complex solution was uniformly coated in the reflector mold, on which a light-emitting element emitting blue light of about 444 nm was mounted, formed from silver (Ag). The nanoparticle-resin complex solution was baked at about 150°C for about two hours to manufacture a light-emitting unit.

The light-emitting units manufactured according to Example 1, Example 2 and Comparative Example 1 were driven with about 60 mA for about 100 hours. Thereafter, the luminous efficiency of the light-emitting units was measured in accordance with time using a spectrometer CAS 140 (product name, National Instruments Corp., U.S.A.) having an integral sphere and thus obtained results are illustrated in FIG. 6.

FIG. 6 is a graph illustrating the luminous efficiency of the light-emitting units manufactured according to Example 1, Example 2 and Comparative Example 1 in accordance with time.

FIG. 6 illustrates a comparative value of the luminous efficiency in accordance with time, when the luminous efficiency of cadmium selenium/zinc sulfide//cadmium sulfide zinc sulfide (CdSe//ZnS/CdSZnS) at initial time is defined as about 1.

Referring to FIG. 6, the luminous efficiency of cadmium selenium//zinc sulfide/cadmium sulfide zinc sulfide (CdSe//ZnS/CdSZnS) at an initial time is 1, the luminous efficiency of the light-emitting unit manufactured according to Comparative Example 1 is about 0.5 after about 20 hours, about 0.4 after about 40 hours, about 0.39 after about 80 hours, and about 0.38 after about 100 hours. Thus, it can be noted that the luminous efficiency of the light-emitting unit manufactured according to Comparative Example Embodiment is decreased by about 60% or more in comparison with the luminous efficiency at the initial time after about 100 hours of time is elapsed.

The luminous efficiency of the light-emitting unit manufactured according to Example 2 is about 0.7 after about 20 hours, about 0.58 after about 40 hours, about 0.58 after about 80 hours, and about 0.56 after about 100 hours. Thus, it can be noted that the luminous efficiency of the light-emitting unit manufactured according to Example 2 is decreased by about 55% in comparison with the luminous efficiency at the initial time after about 100 hours of time is elapsed. A decrease level of the luminous efficiency of the light-emitting unit manufactured according to Example 2 is less than a decrease level of the luminous efficiency of the light-emitting unit manufactured according to Comparative Example 1.

The luminous efficiency of the light-emitting unit manufactured according to Example 1 is about 0.83 after about 20 hours, about 0.72 after about 40 hours, about 0.76 after about 80 hours, and about 0.72 after about 100 hours. Thus, it can be noted that the luminous efficiency of the light-emitting unit manufactured according to Example 1 is decreased by about 30% in comparison with the luminous efficiency of the light-emitting unit manufactured according to Example 1 at the initial time after about 100 hours of time is elapsed. A decrease level of the luminous efficiency of the light-emitting unit manufactured according to Example 1 is less than a decrease level of the luminous efficiency of the light-emitting unit manufactured according to Comparative Example 1 and a decrease level of the luminous efficiency of the light-emitting unit manufactured according to Example 1.

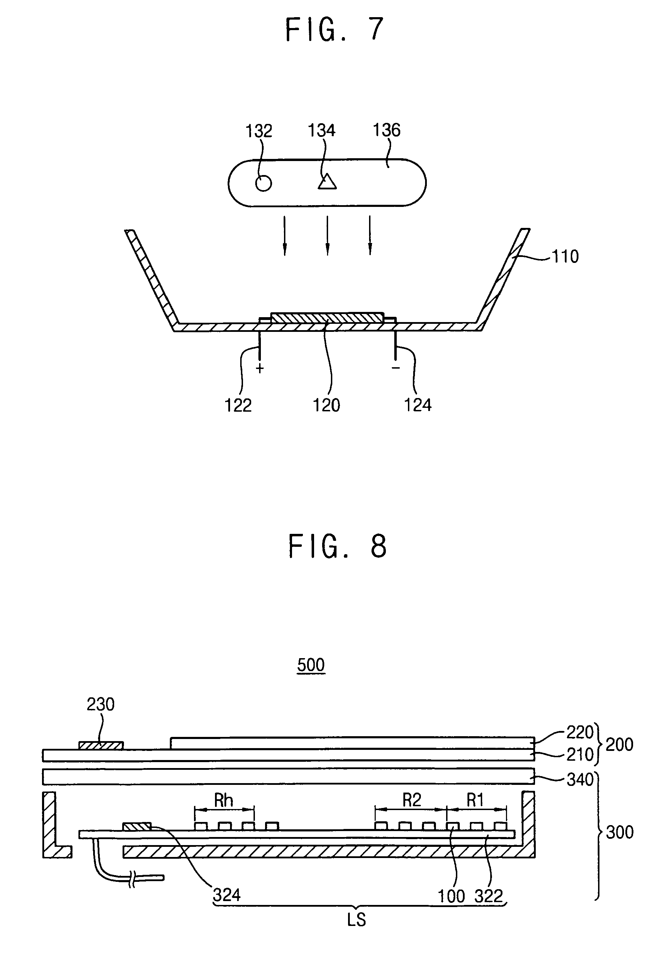

Hereinafter, a method of manufacturing a light-emitting unit is described with reference to FIGS. 1 and 7.

FIG. 7 is a cross-sectional view illustrating a method of manufacturing the light-emitting unit of FIG. 1.

Referring to FIG. 7, the reflector mold 110, on which the light-emitting element 120 is mounted, is prepared, and a nanoparticle-resin complex solution is coated in the reflector mold 110.

For example, the reflector mold may include silver (Ag).

The light-emitting element 120 may be a light-emitting diode (LED) emitting blue light having a wavelength of about 444 nm.

The nanoparticle-resin complex solution includes the nanoparticle 132, the additive 134, and the encapsulant resin 136. The nanoparticle-resin complex solution is filled in the reflector mold 110.

The nanoparticle-resin complex solution filled in the reflector mold 110 is baked for a predetermined time to form the light-converting layer 130. The nanoparticle-resin complex solution may be baked at about 100°C through about 200°C. Therefore, the light-emitting unit 100 may be manufactured.

As described above, according to the present invention, the light-converting layer 130 includes the additive 134 having an oxidation speed faster than an oxidation speed of the nanoparticle 132, and thus a process of an oxidation reaction of the nanoparticle is inhibited. Therefore, the durability of the light-emitting unit 100 may be strengthened and a decrease speed of the luminous efficiency of the light-emitting unit 100 may be declined. Damage of the nanoparticle 132 in the light-converting layer 130 due to external heat energy and/or light energy may be minimized, and thus the light-converting layer 130 may be formed to directly contact with the light-emitting element 120. Therefore, an additional buffer layer is not required to be formed between the light-emitting element 120 and the light-converting layer 130, and thus a manufacturing process of the light-emitting unit 100 may be simplified.

FIG. 8 is a cross-sectional view illustrating a display apparatus including the light-emitting unit of FIG. 1.

Referring to FIG. 8, a display apparatus 500 according to the present invention includes a display panel 200 displaying an image and a backlight assembly 300 generating light.

The display panel 200 may include a first substrate 210 having a thin-film transistor (TFT) that is a switching element, a second substrate 220 facing the first substrate 210 and a liquid crystal layer (not shown) interposed between the first substrate 210 and the second substrate 220. A panel driving part 230 may be mounted on the first substrate 210. The panel driving part 230 may provide a gate signal and/or a data signal to the first substrate 210.

The backlight assembly 300 may include a light source device LS providing light to the display panel 200 and an optical member 340 disposed between the light source device LS and the display panel 200.

The light source device LS includes a plurality of light-emitting units 100 and a light source driving chip 324 driving the light-emitting units 100. The light-emitting units 100 and the light source driving chip 324 may be mounted on a printed circuit board (PCB) 322. The light-emitting units 100 may include a first light-emitting unit emitting red light, a second light-emitting unit emitting green light, and a third light-emitting unit emitting blue light. Alternatively, the light-emitting units 100 may include only light-emitting unit emitting white light.

Each of the light-emitting units 100 includes the light-emitting element 120 and the light-converting layer 130 disposed on the light-emitting element 120. The light-emitting element 120 generates first light and emits the generated first light to the light-converting layer 130. The light-converting layer 130 receives the first light and converts the first light into second light having a wavelength different from a wavelength of the first light to emit the second light to the display panel 200. The nanoparticle 132 in the light-converting layer 130 may convert the first light into the second light. The second light may be a light displaying a red color, a green color, a blue color, or a white color depending on the nanoparticle 132.

The light-emitting units 100 may be divided into a plurality of driving blocks R1, R2 and Rh to be independently driven in correspondence with the respective driving blocks R1, R2 and Rh. A local dimming control part (not shown) electrically connected to the display panel 200 and the light source device LS divides a frame image displayed in the display panel 200 into a plurality of blocks and analyzes an image signal corresponding to the frame image to obtain respective luminances of the driving blocks R1, R2 and Rh. The local dimming control part determines respective dimming levels of the driving blocks R1, R2 and Rh using the obtained luminances and generates respective dimming control signals corresponding to the driving blocks R1, R2 and Rh to output the generated dimming control signals to the display panel 200 and the light source device LS. The light-emitting units 100 of the light source device LS receiving the dimming control signals may be independently driven in correspondence with the respective driving blocks R1, R2 and Rh.

The optical member 340 may uniformly diffuse the second light emitted from the light source device LS to provided the display panel 200 with the diffused second light. The optical member 340 may include a diffusion sheet, a prism sheet, etc.

In FIG. 8, a display apparatus including a direct type backlight assembly is described as an example, however the present invention may be applied to an edge type backlight assembly including a light guiding plate, and thus the light-emitting units of the present invention may be disposed at a side of the light guiding plate.

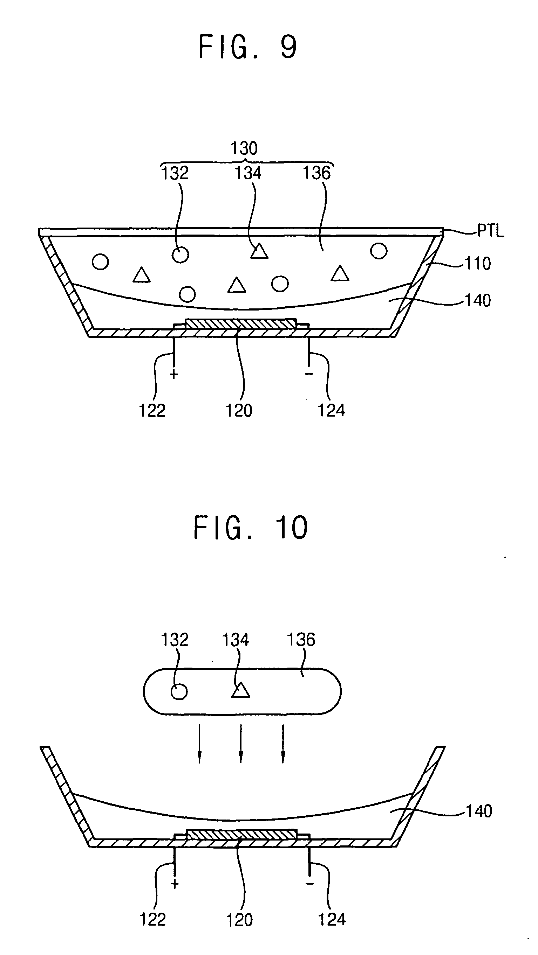

FIGS. 9 to 13 are cross-sectional views illustrating light-emitting units respectively having structures different from a structure of the light-emitting unit of FIG. 1

FIG. 9 is a cross-sectional view illustrating a light-emitting unit including a buffer layer. A light-emitting unit of FIG. 9 is substantially the same as the light-emitting unit of FIG. 1 except for a buffer layer and a cover layer. Therefore, repetitive descriptions may be omitted.

Referring to FIG. 9, a light-emitting unit includes a reflector mold 110, a light-emitting element 120, a buffer layer 140, a light-converting layer 130, and a cover layer PTL.

The buffer layer 140 is formed in the reflector mold 110. The buffer layer 140 may be disposed between the light-emitting element 120 and the light-converting layer 130. The buffer layer 140 may prevent damage to the light-converting layer 130 due to heat and/or light emitted from the light-emitting element 120, which may be caused by a direct contact between the light-emitting element 120 and the light-converting layer 130. For example, the buffer layer 140 may include an acrylic resin. The buffer layer 140 may diffuse the light emitted from the light-emitting element 120 and transfer the diffused light to the light-converting layer 130.

The light-converting layer 130 includes a nanoparticle 132, an additive 134, and an encapsulant resin 136. An oxidation of the nanoparticle may be prevented by the additive 134.

The cover layer PTL may be formed on the light-converting layer 130. The cover layer PTL may prevent damage to the light-converting layer 130 due to an external physical and/or chemical cause. The cover layer PTL may be a protective layer protecting the light-converting layer 130.

FIG. 10 is a cross-sectional view illustrating a method of manufacturing the light-emitting unit of FIG. 9.

Referring to FIG. 10, the reflector mold 110, on which the light-emitting element 120 is mounted, is prepared, and a buffer material is coated in the reflector mold 110 to form the buffer layer 140.

A nanoparticle-resin complex solution is coated in the reflector mold 110 where the buffer layer 140 is formed. The nanoparticle-resin complex solution may include the nanoparticle 132, the additive 134 and the encapsulant resin 136. The nanoparticle-resin complex solution is filled in the reflector mold 110.

The nanoparticle-resin complex solution filled in the reflector mold 110 is baked for a predetermined time to form the light-converting layer 130.

The cover layer PTL covers the reflector mold 110, on which the light-converting layer 130 is formed. The cover layer PTL may be a film formed from a glass substrate or a high molecular resin. The cover layer PTL may be omitted. Therefore, the light-emitting unit illustrated in FIG. 9 may be manufactured.

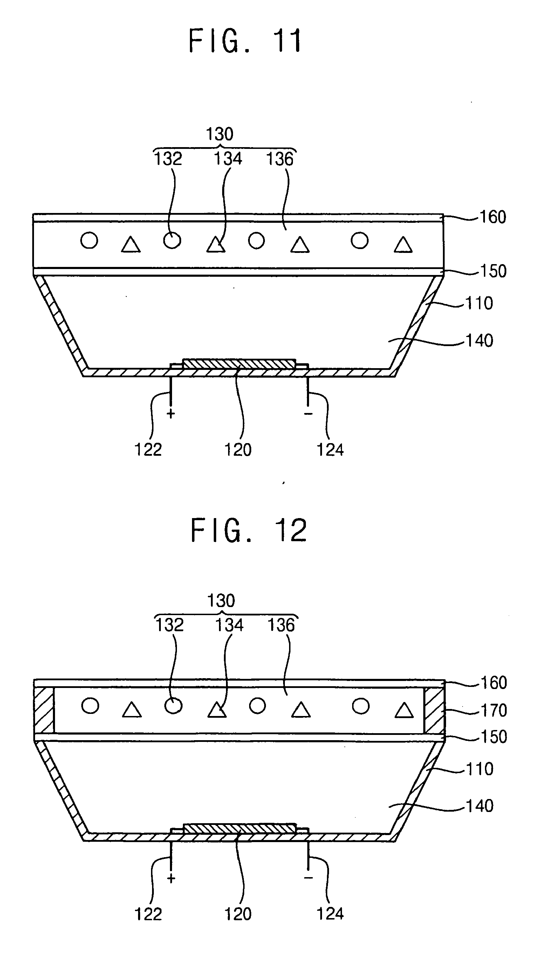

FIG 11 is a cross-sectional view illustrating a light-emitting unit including a middle layer and a protective layer.

Referring to FIG 11, a light-emitting unit includes a reflector mold 110, a light-emitting element 120, a buffer layer 140, a light-converting layer 130, and a protective layer 160.

The reflector mold 110 and the light-emitting element 120 are the same as the reflector mold 110 and the light-emitting element 120 in FIG. 1, and thus repetitive descriptions may be omitted.

The buffer layer 140 is formed in the reflector mold 110. The buffer layer 140 may be filled in the entire area of the internal space of the reflector mold 110. The buffer layer 140 may prevent damage to the light-converting layer 130 due to heat and/or light emitted from the light-emitting element 120, which may be caused by a direct contact between the light-emitting element 120 and the light-converting layer 130. The buffer layer 140 may diffuse the light emitted from the light-emitting element 120 and transfer the diffused light to the light-converting layer 130.

The middle layer is formed on the buffer layer 140. The middle layer 150 protects the buffer layer 140 and planarizes an upper surface of the reflector mold 110, on which the buffer layer 140 is formed. The middle layer 150 may be a film formed from a glass substrate or a high molecular resin.

The light-converting layer 130 is formed on the middle layer 150. The light-converting layer 130 is substantially the same as the light-converting layer of FIG. 1. Therefore, repetitive description may be omitted.

The protective layer 160 is formed on the light-converting layer 130. The protective layer 160 is substantially the same as the cover layer PTL in FIG. 9 in terms of material. Therefore, repetitive descriptions may be omitted.

According to a method of manufacturing the light-emitting unit in FIG 11, the reflector mold 110, on which the light-emitting element 120 is mounted, is prepared and a buffer material is coated in the reflector mold to form the buffer layer 140. The middle layer 150 is formed on the buffer layer 140. A nanoparticle-resin complex solution includes the nanoparticle 132, the additive 134, and the encapsulant resin 136. The nanoparticle-resin complex solution is coated to form the light-converting layer 130. The protective layer 160 is formed on the light-converting layer 130. Therefore, the light-emitting unit illustrated in FIG. 11 may be manufactured.

FIG. 12 is a cross-sectional view illustrating a light-emitting unit including a spacer.

A light-emitting unit of FIG 12 is substantially the same as the light-emitting unit of FIG. 11 except for a spacer. Therefore, repetitive descriptions may be omitted.

Referring to FIG. 12, a light-emitting unit includes a reflector mold 110, a light-emitting element 120, a buffer layer 140, a middle layer 150, a spacer 170, a light-converting layer 130, and a protective layer 160.

The spacer is formed on the middle layer 150. The spacer may invariably maintain a gap of the light-converting layer 130. Particularly, the spacer may invariably maintain an interval between the middle layer 150 and the protective layer 160 to prevent damage to the light-converting unit 130 due to an external force. The spacer 170 may be formed along an edge of the middle layer 150 to prevent the light-converting layer 130 from flowing out.

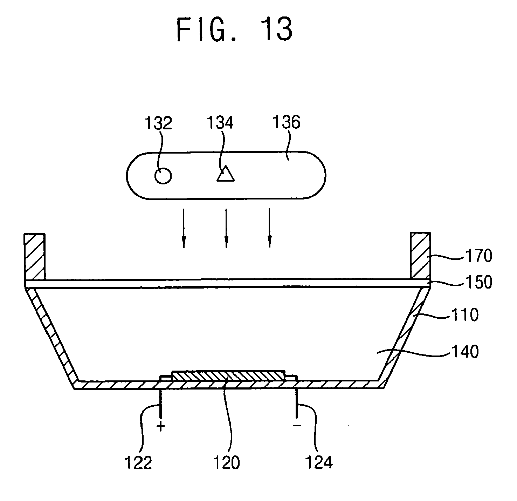

FIG. 13 is a cross-sectional view illustrating a method of manufacturing the light-emitting unit of FIG. 12.

Referring to FIG. 13, the reflector mold 110, on which the light-emitting element 120 is mounted, is prepared, and a buffer material is coated in the reflector mold 110 to form the buffer layer 140. The middle layer 150 is formed on the buffer layer 140. The spacer 170 is formed on the middle layer 150. The spacer 170 may be formed by coating a high molecular resin along an edge of the middle layer 150 and hardening the high molecular resin. A nanoparticle-resin complex solution including the nanoparticle 132, the additive 134, and the encapsulant resin 136 is coated in an internal space defined by the spacer 170 to form the light-converting layer 130. The protective layer 160 is formed on the light-converting layer 130. Therefore, the light-emitting unit illustrated in FIG. 12 may be manufactured.

According to the present invention, oxidation of a nanoparticle may be prevented using an additive, and thus the durability of a light-emitting unit having the nanoparticle may be increased. Therefore, the present invention may increase color reproduction using a nanoparticle and increase the durability of a light-emitting unit, and thus may decrease costs for replacing the light-emitting unit.

The foregoing is illustrative of the present invention and is not to be construed as limiting thereof. Although a few example embodiments of the present invention have been described, those skilled in the art will readily appreciate that many modifications are possible in the example embodiments without materially departing from the novel teachings and advantages of the present invention. Accordingly, all such modifications are intended to be included within the scope of the present invention as defined in the claims. In the claims, means-plus-function clauses are intended to cover the structures described herein as performing the recited function and not only structural equivalents but also equivalent structures. Therefore, it is to be understood that the foregoing is illustrative of the present invention and is not to be construed as limited to the specific example embodiments disclosed, and that modifications to the disclosed example embodiments, as well as other example embodiments, are intended to be included within the scope of the appended claims. The present invention is defined by the following claims, with equivalents of the claims to be included therein.

## Claims

1. A light-emitting unit comprising:
a light-emitting element emitting light; and
a light-converting layer comprising a nanoparticle and an additive having an oxidation speed faster than an oxidation speed of the nanoparticle, the light-converting layer being disposed on the light-emitting element.

2. The light-emitting unit of claim 1, wherein the additive comprises at least one selected from the group consisting of a phenolic compound, a phosphite compound, a quinoline compound, and a piperidine compound.

3. The light-emitting unit of claim 1, wherein the additive comprises at least one selected from the group consisting of 2,6-di-t-butyl-4-methylphenol, tetrakismethylene(3,5-di-t-butyl-4-hydroxyhydrocinnamate)methane, octadecyl 3-(3',5'-di-t-butyl-4'-hydroxyphenyl)propionate, octadecyl 3,5-di-t-butyl-4-hydroxyhydrocinnamate, 3,5-bis(1,1-dimethylethyl)4-hydroxybenzenepropanoic acid, 2,2'-thiodiethylene bis[(3,5-di-t-butyl-4-hydroxyphenyl)propionate], 2,2'-methylidene bis[4,6-di-t-butylphenol], 1,3,5-tri(3,5-di-t-butyl-4-hydroxybenzyl)isocyanurate, 2,2'-methylene bis[(6-t-butyl-4-hydroxy-5-methylphenyl)propionate], N,N'-hexamethylene bis[3-(3,5-di-t-butyl-4-hydroxyphenyl)propionamide], 4,4'-thiobis(2-t-butyl-5-methylphenol), 2,2'-thiobis(6-t-butyl-4-methylphenol), 2,2'-methylene bis[4-methyl-6-(1-methylcyclohexyl)phenol], 1,2-bis(3,5-di-t-butyl-4-hydroxyhydrocinnamyl)hydrazine, tris(2,4-di-t-butylphenyl)phosphite, bis(2,4-di-t-butylphenyl)pentaerythritol diphosphite, bis(2,4-dicumylphenyl) pentaerythritol diphosphite, tri-(4-n-nonylphenyl)phosphite, tetrakis(2,4-di-t-butyl-phenyl)4,4'-biphenylene-diphosphite, trimethyl quinoline, and bis(2,2,6,6-tetramethyl-4-piperidinyl)sebacate.

4. The light-emitting unit of claim 1, wherein the light-converting layer further comprises an encapsulant resin fixing the nanoparticle and the additive to a base substrate, on which the light-emitting element is mounted.

5. The light-emitting unit of claim 1, wherein the nanoparticle comprises sulfur (S).

6. The light-emitting unit of claim 1, wherein the nanoparticle comprises at least one selected from the group consisting of cadmium sulfide (CdS), zinc sulfide (ZnS), mercury sulfide (HgS), cadmium selenium sulfide (CdSeS), mercury selenium sulfide (HgSeS), cadmium zinc sulfide (CdZnS), cadmium mercury sulfide (CdHgS), mercury zinc sulfide (HgZnS), tin sulfide (SnS), lead sulfide (PbS), tin selenium sulfide (SnSeS), lead selenium sulfide (PbSeS) and tin lead sulfide (SnPbS).

7. The light-emitting unit of claim 1, further comprising:
a buffer layer disposed between the light-emitting element and the light-converting layer.

8. The light-emitting unit of claim 7, further comprising:
a spacer maintaining a gap of the light-converting layer and preventing the light-converting layer from flowing out, the spacer being disposed on the buffer layer.

9. The light-emitting unit of claim 7, further comprising:
a middle layer disposed between the buffer layer and the light-converting layer.

10. The light-emitting unit of claim 1, further comprising:
a protective layer disposed on the light-converting layer.
